# EUROPÄISCHE PATENTSCHRIFT

(11) **EP 1 470 469 B1**
(45) Veröffentlichungstag und Bekanntmachung des Hinweises auf die Patenterteilung: **04.04.2018**
(21) Anmeldenummer: 03704228.0
(22) Anmeldetag: 17.01.2003
(51) Int. Cl.: G06F 1/28, G06F 1/30, F02N 11/08, G11C 16/22

(54) **VERFAHREN ZUR BERWACHUNG DER BETRIEBSBEREITSCHAFT MINDESTEN S EINES EINER ELEKTRONISCHEN EINHEIT ZUGEORDNETEN SPEICHERELEMENTS**
METHOD FOR MONITORING THE AVAILABILITY OF AT LEAST ONE MEMORY ELEMENT THAT IS ASSIGNED TO AN ELECTRONIC UNIT
PROCÉDÉ DE SURVEILLANCE DE LA DISPONIBILITÉ D'AU MOINS UN ÉLÉMENT DE MÉMOIRE ASSOCIÉ À UNE UNITÉ ÉLECTRONIQUE

(30) Priorität: 19.01.2002 DE 10201958
(43) Veröffentlichungstag der Anmeldung: 27.10.2004
(73) Patentinhaber: ROBERT BOSCH GMBH, 70442 Stuttgart (DE)
(72) Erfinder: STEINLE, Claus, 70567 Stuttgart (DE); AUE, Axel, 70825 Korntal-Muenchingen (DE)
(86) Internationale Anmeldenummer: PCT/DE2003/000128
(87) Internationale Veröffentlichungsnummer: WO 2003/060922

(56) Entgegenhaltungen:
- EP-A- 0 049 462
- EP-A- 0 604 270
- EP-A- 1 003 290
- EP-A2- 0 574 743
- EP-A2- 1 069 495
- DE-A- 3 310 585
- DE-A- 19 601 804
- DE-A1- 4 111 875
- JP-A- H03 130 885
- US-A- 5 539 910
- US-A- 5 673 417
- US-A- 5 889 721
- US-A- 6 148 418
- US-B1- 6 301 528
- US-B1- 6 314 307

## Beschreibung

Die Erfindung betrifft ein Verfahren zur Überwachung der Betriebsbereitschaft mindestens eines Speicherelements, das einer elektronischen Einheit zugeordnet ist, und eine elektronische Einheit zur Durchführung des Verfahrens. Die Erfindung betrifft weiterhin ein Computerprogramm zur Durchführung des erfindungsgemäßen Verfahrens.

### Stand der Technik

In elektronischen Einheiten, wie bspw. in Motorsteuergeräten, werden zur Speicherung von Programmcode bspw. Flash-EPROMs verwendet. Auf modernen Controllern ist es außerdem üblich, Flash-Speicherelemente zu integrieren, um möglichst schnell Programme ausführen zu können. Dabei ist jedoch zu beachten, daß das integrierte Flash-Speicherelement wesentlich teurer ist als ein externer Flash-Speicher-IC, der im Vergleich zu diesem jedoch langsamer ist. Aus diesem Grunde werden für Programmteile, die nicht die Leistungsfähigkeit des gesamten Systems beeinflussen, externe (stand-alone) Flash-Speicher-ICs eingesetzt.

Hierbei stellt sich das Problem, daß die verschiedenen ICs für Rechner und Speicher in verschiedenen Technologien gefertigt sind und daher mit unterschiedlichen Betriebsspannungen arbeiten. Selbst auf dem Rechner können die Betriebsspannungen für den Rechnerkern und die Betriebsspannung des Flash-Speichers technologiebedingt unterschiedlich sein. In der Regel ist die Betriebsspannung des Flash-Speichers höher als die des Rechnerkerns. Der Programmablauf ist aber nur dann sichergestellt, wenn die Betriebsspannung für den Speicher, auf dem das zur Ausführung kommende Programm gespeichert ist, und für den Rechnerkern innerhalb einer spezifizierten Toleranzschwelle liegt.

Für einen Versorgungsspannungseinbruch der Motorsteuerung sind Unterspannungserkennungen der Betriebsspannungen mit dazugehöriger Fehlerbehandlung notwendig.

Aus der Druckschrift DE 196 01 804 A1 sind ein Verfahren und eine Vorrichtung zum Überwachen einer elektronischen Recheneinheit bekannt. Bei dem beschriebenen Verfahren wird nach einer Initialisierung der Recheneinheit bei einer Störung der Versorgungsspannung von einer Spannungsüberwachungseinrichtung an die Recheneinheit ein Reset-Signal abgegeben und der Betriebszustand der Recheneinheit nach Auftreten des Signals durch Vergleich eines Inhalts einer flüchtigen Speichereinrichtung mit einem fest vorgegebenen Code überprüft. Anhand dieser Überprüfung wird eine Entscheidung bezüglich des weiteren Steuerungsablaufs getroffen. Nach Auslösen eines Reset-Signals wird der Inhalt einer flüchtigen

Speichereinrichtung mit einem vorgegebenen Code verglichen. Somit wird bei jedem Reset-Signal eine Überprüfung in Gang gesetzt, bei der getestet wird, ob der Inhalt des flüchtigen Speichers noch vollständig vorhanden ist. Damit können Störungen der Spannungsversorgung, die Fehler in der Recheneinheit verursachen, von solchen Störungen der Spannungsversorgung unterschieden werden, die keine Fehler in der Recheneinheit hervorrufen.

Je nach Stärke eines Versorgungsspannungseinbruchs kann es dazu kommen, dass die höchste Betriebsspannung für einen Teil des Flash-Speichers nicht mehr ausreicht, aber die anderen Betriebsspannungen für die anderen Flash-Teile und den Rechnerkern noch in der spezifizierten Toleranz sind. Der normale Programmablauf ist damit aber nicht mehr möglich, weil davon ausgegangen wird, dass immer der gesamte Flash-Speicher zur Verfügung stehen muss.

Üblicherweise wird eine Unterspannung auf der Betriebsspannung über einen Schwellwert mit Hysterese erkannt. Voraussetzung dafür ist jedoch, dass der Schwellwert höher ist als die Mindestbetriebsspannung des Speichers, jedoch auch kleiner als die geringste durch Störungen auftretende Betriebsspannung. Ist die Betriebsspannung des Flash-Speichers sehr eng toleriert, ist eine solche Auswertung allerdings nicht mehr möglich.

Aus der US 5,673,417 und der US 5,889,721 sind bereits Verfahren zur Speicherverwaltung von Flash-Speichern bekannt. Aus der US6,301,528 ist ein Belastungsmanagement von elektrischen Verbrauchen in einem Fahrzeug bekannt. Die EP 1 069 495 A1 beschreibt eine Unterspannungserkennung eines Fahrzeugrechners.

### Vorteile der Erfindung

Das erfindungsgemäße Verfahren dient zur Überwachung der Betriebsbereitschaft mindestens eines Speicherelements, das einer elektronischen Einheit zugeordnet ist. Die Betriebsbereitschaft des Speicherelements bzw. der Speicherelemente wird dadurch überprüft, dass eine

Versorgungsspannung der elektronischen Einheit überwacht wird. Auf diese Weise kann die fehlerfreie Funktionsweise der gesamten elektronischen Einheit sichergestellt werden.

Das erfindungsgemäße Verfahren ermöglicht insbesondere die Überwachung mehrerer Speicherelemente, sowohl externer als auch interner, die unterschiedliche Betriebsspannungen benötigen, und ermöglicht auch eine Aussage darüber zu treffen, welche der unterschiedlichen Speicherelemente bei einer bestimmten Versorgungsspannung noch betriebsbereit sind.

Statt der Überwachung der Betriebsspannung bzw. der Betriebsspannungen des mindestens einen Speicherelements wird somit die Versorgungsspannung der elektronischen Einheit, bspw. einer Motorsteuerung, überwacht. Damit ist ein rechtzeitiges Erkennen der Unterschreitung der Betriebsspannung an dem mindestens einen Speicherelement möglich.

Die Auswertung der Schwellwertunterschreitung bspw. mit einer vorgesehenen Recheneinheit kann je nach Anforderung an Genauigkeit und Reaktionsgeschwindigkeit, auch in Abhängigkeit vom Gesamtkonzept für die Motorsteuerung, unterschiedlich erfolgen.

Eine Möglichkeit sieht vor, daß die Versorgungsspannung zunächst heruntergeteilt wird. Die heruntergeteilte Versorgungsspannung kann dann bspw. mit einem Analog-Digital-Converter (ADC) vorzugsweise zyklisch gemessen, mit einem allgemeinen Eingang (General Purpose Input) der Recheneinheit zyklisch eingelesen (polling) und/oder an einem Interrupt-Eingang der elektronischen Recheneinheit ausgewertet werden.

Eine andere Möglichkeit sieht vor, daß die Versorgungsspannung in einen Komparator eingegeben wird, dessen Ausgangssignal zur Überwachung der Versorgungsspannung ausgewertet wird. Die Auswertung erfolgt bspw. dadurch, daß das Ausgangssignal an einem allgemeinen Eingang (General Purpose Input) der elektronischen Recheneinheit zyklisch eingelesen (polling) und/oder an einem Interrupt-Eingang der elektronischen Recheneinheit ausgewertet wird.

In Ausgestaltung der Erfindung ist vorgesehen, daß zusätzlich noch die Betriebsspannung des mindestens einen Speicherelements überwacht wird.

Sind z. B. mehrere Speicherelemente vorgesehen, die unterschiedlich hohe Betriebsspannungen benötigen, kann bei der Erkennung einer Unterspannung an einem Speicherelement von der Recheneinheit nur noch Programmcode aus Speicherelementen abgearbeitet werden, an denen eine ausreichende Betriebsspannung anliegt. Damit kann bspw. bei einem Kraftfahrzeug eine eingeschränkte Funktionalität (z. B. beim Start) weiter gewährleistet werden. Sobald erkannt wird, daß die Betriebsspannung für alle Speicherelemente bzw. für alle Teile eines Speicherelements, bspw. eines Flash-Speicherelements, im spezifizierten Bereich liegt, kann wieder der gesamte Programmcode genutzt werden.

Die erfindungsgemäße elektronische Einheit, bspw. ein Motorsteuergerät, ist mit einer bestimmten Versorgungsspannung betrieben. Der Einheit ist mindestens ein Speicherelement zugeordnet. Speicherelemente können Flash-Speicherelemente aber auch andere bekannte Speicherelemente sein, wobei auch Speicherelemente unterschiedlichen Typs verwendet werden können. Die elektronische Einheit ist so ausgebildet, daß zur Überwachung der Betriebsfähigkeit des mindestens einen Speicherelements eine Überwachung der Versorgungsspannung der elektronischen Einheit vorgesehen ist.

Zur Überwachung dient eine geeignete Einrichtung, die es anhand der überwachten Versorgungsspannung der elektronischen Einheit erlaubt festzustellen, welche der Speicherelemente betriebsbereit sind. Somit kann der sichere Betrieb der gesamten elektronischen Einheit gewährleistet werden.

Vorzugsweise weist die elektronische Einheit eine Recheneinheit, bspw. einen Mikroprozessor oder einen Controller, auf.

In Ausgestaltung der Erfindung ist zur Überwachung der Versorgungsspannung ein Analog-Digital-Converter (ADC) vorgesehen. Eine alternative Ausführungsform sieht vor, daß zur Überwachung der Versorgungsspannung ein Komparator vorgesehen ist.

Selbstverständlich ist eine Ausführungsform möglich, bei der sowohl ein Komparator als auch ein Analog-Digital-Converter vorgesehen ist, so daß die unterschiedlichen Verfahren zur Überwachung der Versorgungsspannung beliebig kombiniert werden können, um eine gewünschte Redundanz zu erzielen.

Das erfindungsgemäße Computerprogramm umfaßt Programmcodemittel, um ein vorstehend beschriebenes Verfahren durchzuführen. Dieses kommt dabei auf einem Computer oder einer entsprechenden Recheneinheit zur Ausführung. Die Recheneinheit ist vorzugsweise eine elektronische Recheneinheit in einer erfindungsgemäßen elektronischen Einheit.

Das erfindungsgemäße Computerprogrammprodukt sieht vor, daß die Programmcodemittel auf einem computerlesbaren Datenträger gespeichert sind.

Weitere Vorteile und Ausgestaltungen der Erfindung ergeben sich aus der Beschreibung und der beiliegenden Zeichnung.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung dargestellt und wird im folgenden unter Bezugnahme auf die Zeichnung näher erläutert.
- Figur 1: zeigt eine bevorzugte Ausführungsform der erfindungsgemäßen elektronischen Einheit in schematischer Darstellung.
- Figur 2: zeigt eine bevorzugte Ausführungsform des erfindungsgemäßen Verfahrens in einem Flußdiagramm.

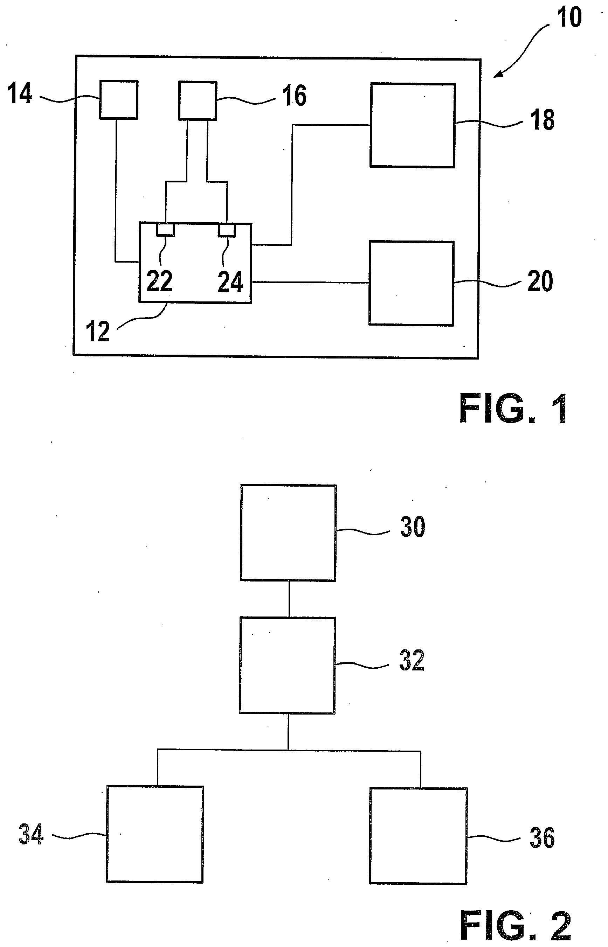

In Figur 1 ist eine erfindungsgemäße elektronische Einheit, in diesem Fall ein Motorsteuergerät 10, schematisch dargestellt. Zu erkennen sind eine elektronische Recheneinheit 12, nämlich ein Controller 12, ein Analog-Digital-Converter (ADC) 14, ein Komparator 16, ein erstes Speicherelement 18 und ein zweites Speicherelement 20. Die Speicherelemente 18 und 20 sind in diesem Fall Flash-Speicherelemente 18 und 20.

Der Controller 12 verfügt über einen allgemeinen Eingang 22 und einen Interrupt-Eingang 24. Die benötigte Betriebsspannung des Controllers 12 unterscheidet sich von den erforderlichen Betriebsspannungen des ersten und des zweiten Speicherelements 18 und 20, die wiederum unterschiedlich hohe Betriebsspannungen benötigen.

Zur Überwachung der Betriebsbereitschaft der beiden Speicherelemente 18 und 20 wird die Versorgungsspannung des Motorsteuergeräts 10 herangezogen. Dabei gibt es unterschiedliche Möglichkeiten. So kann die Versorgungsspannung des Motorsteuergeräts 10 zunächst heruntergeteilt werden und die heruntergeteilte Versorgungsspannung dann mit dem ADC 14 gemessen, an dem allgemeinen Eingang 22 eingelesen und/oder an dem Interrupt-Eingang 24 ausgewertet werden.

Alternativ dazu oder auch ergänzend kann die Versorgungsspannung in den Komparator 16 eingegeben werden, dessen Ausgangssignal dann zur Auswertung an dem allgemeinen Eingang 22 vorzugsweise zyklisch eingelesen oder an dem Interrupt-Eingang 24 ausgewertet wird.

In Figur 2 ist anhand eines Flußdiagramms ein erfindungsgemäßes Verfahren wiedergegeben. Mit einem Schritt 30 wird das Motorsteuergerät 10 in Betrieb genommen. Zur Überwachung der Betriebsbereitschaft der beiden Speicherelemente 18 und 20 wird in einem Schritt 32 die Versorgungsspannung des Motorsteuergeräts 10 überwacht. Wird anhand der Versorgungsspannung festgestellt, daß bspw. nur noch das erste Speicherelement 18 betriebsbereit ist, wird der Controller 12 in einem Schritt 34 nur noch Programmcode aus diesem Speicherelement 18 auslesen und abarbeiten und zwar solange, bis die Betriebsspannung auch des zweiten Speicherelements 20 wieder im spezifizierten Bereich ist.

Ergibt die Überwachung keinen Unterschwellenwert wird in einem Schritt 36 Programmcode aus beiden Speicherelementen 18 und 20 bearbeitet.

Ein besonderer Vorteil des erfindungsgemäßen Verfahrens liegt darin, daß die Anforderungen an die Versorgungsspannung der Motorsteuerung 10 geringer als an die Betriebsspannungen der Speicherelemente 18 und 20 sind, weil kurzzeitige Spannungseinbrüche, bspw. beim Start des Kraftfahrzeugs, insbesondere mit einer schwachen Batterie, und/oder im Fahrbetrieb überbrückt werden können.

## Patentansprüche

1. Verfahren zur Überwachung der Betriebsbereitschaft zweier einer Motorsteuerung (10) zugeordneten Speicherelemente (18, 20), bei dem eine Versorgungsspannung der Motorsteuerung (10) überwacht wird, wobei die Anforderungen an die Betriebsspannung der Motorsteuerung (10) geringer als die Betriebsspannungen der Speicherelemente (18, 20) sind, wobei die Speicherelemente (18, 20) wiederum unterschiedlich hohe Betriebsspannungen benötigen, die jeweils in einem spezifizierten Bereich liegt, damit das entsprechende Speicherelement (18, 20) betriebsbereit ist, **dadurch gekennzeichnet, dass** zur Gewährleistung einer Funktionalität eines Kraftfahrzeug beim Start wenn aufgrund der Überwachung der Versorgungsspannung der Motorsteuerung (10) erkannt wird, dass die Betriebsspannung eines der beiden Speicherelemente (18, 20) nicht mehr in dem jeweils spezifizierten Bereich liegt, nur noch Programmcode aus dem Speicherelement (18, 20) abgearbeitet wird, dessen Betriebsspannung in dem jeweils spezifizierten Bereich liegt, so dass die Funktionalität des Kraftfahrzeuges auch bei Spannungseinbrüchen beim Start gewährleistet ist.

2. Verfahren nach Anspruch 1, bei dem die Überwachung der Versorgungsspannung dadurch erfolgt, dass diese zunächst heruntergeteilt wird.

3. Verfahren nach Anspruch 2, bei dem die heruntergeteilte Versorgungsspannung mit einem Analog-Digital-Converter (14) zyklisch gemessen wird.

4. Verfahren nach Anspruch 2, bei dem die heruntergeteilte Versorgungsspannung an einem allgemeinen Eingang (22) einer elektronischen Recheneinheit (12) der Motorsteuerung (10) zyklisch eingelesen wird.

5. Verfahren nach Anspruch 2, bei dem die heruntergeteilte Versorgungsspannung an einem Interrupt-Eingang (24) einer elektronischen Recheneinheit (12) der Motorsteuerung (10) ausgewertet wird.

6. Verfahren nach Anspruch 1, bei dem die Versorgungsspannung in einen Komparator (16) eingegeben wird, dessen Ausgangssignal zur Überwachung der Versorgungsspannung ausgewertet wird.

7. Verfahren nach Anspruch 6, bei dem das Ausgangssignal des Komparators (16) an einem allgemeinen Eingang (22) einer elektronischen Recheneinheit (12) der Motorsteuerung (10) zyklisch eingelesen wird.

8. Verfahren nach Anspruch 6, bei dem das Ausgangssignal des Komparators (16) an einem Interrupt-Eingang (24) einer elektronischen Recheneinheit (12) der Motorsteuerung (10) ausgewertet wird.

9. Verfahren nach einem der Ansprüche 1 bis 8, bei dem zusätzlich zur Versorgungsspannung der Motorsteuerung (10) die Betriebsspannung des mindestens einen Speicherelements (18, 20) überwacht wird.

10. Motorsteuerung (10), die mit einer Versorgungsspannung betrieben wird und der zwei Speicherelemente (18, 20) zugeordnet sind, wobei die Motorsteuerung (10) so ausgebildet ist, dass zur Überwachung der Betriebsfähigkeit der zwei Speicherelemente (18, 20) eine Überwachung der Versorgungsspannung der Motorsteuerung (10) vorgesehen ist, wobei die Anforderungen an die Betriebsspannung der Motorsteuerung (10) geringer als die Betriebsspannungen der Speicherelemente (18, 20) sind, wobei die Speicherelemente (18, 20) wiederum unterschiedlich hohe Betriebsspannungen benötigen, die jeweils in einem spezifizierten Bereich liegt, damit das entsprechende Speicherelement betriebsbereit ist, **dadurch gekennzeichnet, dass** die Motorsteuerung (10) die Funktionalität eines Kraftfahrzeugs bei einem Start gewährleistet wenn aufgrund der Überwachung der Versorgungsspannung der Motorsteuerung (10) erkannt wird, dass die Betriebsspannung eines der beiden Speicherelemente nicht mehr in dem jeweils spezifizierten Bereich liegt, indem nur noch Programmcode aus dem Speicherelement abgearbeitet wird, dessen Betriebsspannung in dem jeweils spezifizierten Bereich liegt, so dass die Funktionalität des Kraftfahrzeuges auch bei Spannungseinbrüchen beim Start gewährleistet ist.

11. Motorsteuerung (10) nach Anspruch 10, die eine elektronische Recheneinheit (12) aufweist.

12. Motorsteuerung (10) nach Anspruch 10 oder 11, bei der das mindestens eine Speicherelement (18, 20) ein Flash-Speicherelement (18, 20) ist.

13. Motorsteuerung (10) nach einem der Ansprüche 10 bis 12 bei der zur Überwachung der Versorgungsspannung ein Analog-Digital-Converter (14) vorgesehen ist.

14. Motorsteuerung (10) nach einem der Ansprüche 10 bis 13, bei der zur Überwachung der Versorgungsspannung ein Komparator (16) vorgesehen ist.

15. Computerprogramm mit Programmcodemitteln, um ein Verfahren nach einem der Ansprüche 1 bis 9 auszuführen, wenn das Computerprogramm auf einem Computer oder einer entsprechenden Recheneinheit, insbesondere einer Recheneinheit (12) in einer Motorsteuerung (10) nach Anspruch 11, durchgeführt wird.

16. Computerprogrammprodukt mit Programmcodemitteln, die auf einem computerlesbaren Datenträger gespeichert sind, um ein Verfahren nach einem der Ansprüche 1 bis 9 auszuführen, wenn das Computerprogramm auf einem Computer oder einer entsprechenden Recheneinheit, insbesondere einer Recheneinheit (12) in einer Motorsteuerung (10) nach Anspruch 11, durchgeführt wird.

## Claims

1. Method for monitoring the availability of two memory elements (18, 20) assigned to an engine controller (10), in which a supply voltage of the engine controller (10) is monitored, wherein the demands imposed on the operating voltage of the engine controller (10) are lower than the operating voltages of the memory elements (18, 20), wherein the memory elements (18, 20) in turn require operating voltages of different levels which are each in a specified range so that the corresponding memory element (18, 20) is available, **characterized in that**, in order to ensure a functionality of a motor vehicle during starting if it is detected, on the basis of the monitoring of the supply voltage of the engine controller (10), that the operating voltage of one of the two memory elements (18, 20) is no longer in the respectively specified range, only program code from that memory element (18, 20) whose operating voltage is in the respectively specified range is executed, with the result that the functionality of the motor vehicle is ensured even in the event of voltage dips during starting.

2. Method according to Claim 1, in which the supply voltage is monitored by first of all dividing it down.

3. Method according to Claim 2, in which the divided-down supply voltage is cyclically measured using an analogue/digital converter (14).

4. Method according to Claim 2, in which the divided-down supply voltage is cyclically polled at a general-purpose input (22) of an electronic computing unit (12) of the engine controller (10).

5. Method according to Claim 2, in which the divided-down supply voltage is evaluated at an interrupt input (24) of an electronic computing unit (12) of the engine controller (10).

6. Method according to Claim 1, in which the supply voltage is input to a comparator (16), the output signal of which is evaluated for the purpose of monitoring the supply voltage.

7. Method according to Claim 6, in which the output signal of the comparator (16) is cyclically polled at a general-purpose input (22) of an electronic computing unit (12) of the engine controller (10).

8. Method according to Claim 6, in which the output signal of the comparator (16) is evaluated at an interrupt input (24) of an electronic computing unit (12) of the engine controller (10).

9. Method according to one of Claims 1 to 8, in which, in addition to the supply voltage of the engine controller (10), the operating voltage of the at least one memory element (18, 20) is monitored.

10. Engine controller (10) which is operated with a supply voltage and is assigned two memory elements (18, 20), wherein the engine controller (10) is designed in such a manner that, in order to monitor the availability of the two memory elements (18, 20), provision is made for the supply voltage of the engine controller (10) to be monitored, wherein the demands imposed on the operating voltage of the engine controller (10) are lower than the operating voltages of the memory elements (18, 20), wherein the memory elements (18, 20) in turn require operating voltages of different levels which are each in a specified range so that the corresponding memory element is available, **characterized in that** the engine controller (10) ensures the functionality of a motor vehicle during starting, if it is detected, on the basis of the monitoring of the supply voltage of the engine controller (10), that the operating voltage of one of the two memory elements is no longer in the respectively specified range, by executing only program code from that memory element whose operating voltage is in the respectively specified range, with the result that the functionality of the motor vehicle is ensured even in the event of voltage dips during starting.

11. Engine controller (10) according to Claim 10, which has an electronic computing unit (12).

12. Engine controller (10) according to Claim 10 or 11, in which the at least one memory element (18, 20) is a flash memory element (18, 20).

13. Engine controller (10) according to one of Claims 10 to 12, in which an analogue/digital converter (14) is provided for the purpose of monitoring the supply voltage.

14. Engine controller (10) according to one of Claims 10 to 13, in which a comparator (16) is provided for the purpose of monitoring the supply voltage.

15. Computer program having program code means in order to carry out a method according to one of Claims 1 to 9 when the computer program is executed on a computer or a corresponding computing unit, in particular a computing unit (12) in an engine controller (10) according to Claim 11.

16. Computer program product having program code means which are stored on a computer-readable data storage medium in order to carry out a method according to one of Claims 1 to 9 when the computer program is executed on a computer or a corresponding computing unit, in particular a computing unit (12) in an engine controller (10) according to Claim 11.

## Revendications

1. Procédé pour surveiller la disponibilité fonctionnelle de deux éléments de mémoire (18, 20) associés à une unité de commande de moteur (10), dans lequel une tension d'alimentation de l'unité de commande de moteur (10) est surveillée, dans lequel les exigences concernant la tension de fonctionnement de l'unité de commande de moteur (10) sont inférieures aux tensions de fonctionnement des éléments de mémoire (18, 20), dans lequel les éléments de mémoire (18, 20) nécessitent quant à eux des tensions de fonctionnement différentes, qui se situent respectivement dans une plage spécifiée, de sorte que l'élément de mémoire correspondant (18) est fonctionnellement disponible, **caractérisé en ce que** le bon fonctionnement d'un véhicule à moteur au démarrage est garanti lorsqu'il est détecté, en raison de la surveillance de la tension d'alimentation de l'unité de commande de moteur (10), que la tension de fonctionnement de l'un des deux éléments de mémoire (18, 20) ne se situe plus dans la plage spécifiée respective, en ne traitant que le code de programme provenant de l'élément de mémoire (18, 20) dont la tension de fonctionnement se situe dans la plage spécifiée respective, de sorte que le bon fonctionnement du véhicule automobile est garanti au démarrage même en cas de chute de tension.

2. Procédé selon la revendication 1, dans lequel la surveillance de la tension d'alimentation est effectuée en faisant en sorte que celle-ci soit tout d'abord divisée.

3. Procédé selon la revendication 2, dans lequel la tension d'alimentation divisée est mesurée cycliquement au moyen d'un convertisseur analogique-numérique (14).

4. Procédé selon la revendication 2, dans lequel la tension d'alimentation divisée est lue cycliquement sur une entrée générale (22) d'une unité de calcul électronique (12) de l'unité de commande de moteur (10).

5. Procédé selon la revendication 2, dans lequel la tension d'alimentation divisée est évaluée sur une entrée d'interruption (24) d'une unité de calcul électronique (12) de l'unité de commande de moteur (10).

6. Procédé selon la revendication 1, dans lequel la tension d'alimentation est fournie en entrée à un comparateur (16) dont le signal de sortie est évalué pour la surveillance de la tension d'alimentation.

7. Procédé selon la revendication 6, dans lequel le signal de sortie du comparateur (16) est lu cycliquement sur une entrée générale (22) d'une unité de calcul électronique (12) de l'unité de commande de moteur (10) .

8. Procédé selon la revendication 6, dans lequel le signal de sortie du comparateur (16) est évalué sur une entrée d'interruption (24) d'une unité de calcul électronique (12) de l'unité de commande de moteur (10).

9. Procédé selon l'une quelconque des revendications 1 à 8, dans lequel la tension de fonctionnement d'au moins un élément de mémoire (18, 20) est surveillée en plus de la tension d'alimentation de l'unité de commande de moteur (10).

10. Unité de commande de moteur (10) qui est mise en fonctionnement avec une tension d'alimentation et à laquelle sont associés deux éléments de mémoire (18, 20), dans laquelle l'unité de commande de moteur (10) est conçue de manière à ce qu'une surveillance de la tension d'alimentation de l'unité de commande de moteur (10) soit prévue pour surveiller la disponibilité fonctionnelle des deux éléments de mémoire (18, 20), dans laquelle les exigences concernant la tension de fonctionnement de l'unité de commande de moteur (10) sont inférieures aux tensions de fonctionnement des éléments de mémoire (18, 20), dans laquelle les éléments de mémoire (18, 20) nécessitent quant à eux des tensions de fonctionnement différentes, qui se situent respectivement dans une plage spécifiée, de sorte que l'élément de mémoire correspondant est fonctionnellement disponible, **caractérisée en ce que** l'unité de commande de moteur (10) garantit le bon fonctionnement d'un véhicule automobile au démarrage lorsqu'il est détecté, en raison de la surveillance de la tension d'alimentation de l'unité de commande de moteur (10), que la tension de fonctionnement de l'un des deux éléments de mémoire ne se situe plus dans la plage spécifiée respective, en ne traitant que le code de programme de traitement provenant de l'élément de mémoire dont la tension de fonctionnement se situe dans la plage spécifiée respective, de sorte que le bon fonctionnement du véhicule automobile est garanti au démarrage même en cas de chute de tension.

11. Unité de commande de moteur (10) selon la revendication 10, comportant une unité de calcul électronique (12).

12. Unité de commande de moteur (10) selon la revendication 10 ou 11, dans laquelle ledit au moins un élément de mémoire (18, 20) est un élément de mémoire flash (18, 20).

13. Unité de commande de moteur (10) selon l'une quelconque des revendications 10 à 12, dans laquelle il est prévu un convertisseur analogique-numérique (14) pour la surveillance de la tension d'alimentation.

14. Unité de commande de moteur (10) selon l'une quelconque des revendications 10 à 13, dans laquelle il est prévu un comparateur (16) pour la surveillance de la tension d'alimentation.

15. Programme d'ordinateur comportant des moyens à code de programme pour mettre en oeuvre un procédé selon l'une quelconque des revendications 1 à 9 lorsque le programme d'ordinateur est exécuté sur un ordinateur ou une unité de calcul correspondante, en particulier un processeur (12) dans une unité de commande de moteur (10) selon la revendication 11.

16. Produit de programme d'ordinateur comportant des moyens à code de programme stockés sur un support de données lisible par ordinateur pour mettre en oeuvre un procédé selon l'une quelconque des revendications 1 à 9 lorsque le programme d'ordinateur est exécuté sur un ordinateur ou une unité de calcul correspondante, en particulier une unité de calcul (12) dans un système de commande de moteur (10) selon la revendication 11.
